# EUROPEAN PATENT APPLICATION

(11) **EP 4 823 283 A1**
(43) Date of publication of application: **14.10.2026**
(21) Application number: 24930828.9
(22) Date of filing: 21.03.2024
(51) Int. Cl.: H10F 77/20, H10F 10/16, H10F 10/161

(54) **TRANSPARENT ELECTRODE, SOLAR CELL, MULTI-JUNCTION SOLAR CELL, SOLAR CELL MODULE, AND PHOTOVOLTAIC POWER GENERATION SYSTEM**

(71) Applicant: KABUSHIKI KAISHA TOSHIBA, Kawasaki-shi, Kanagawa 212-0013 (JP)
(72) Inventor: NAKAGAWA, Naoyuki, Tokyo 105-0023 (JP); YAMAMOTO, Takashi, Tokyo 105-0023 (JP); HONISHI, Yuya, Tokyo 105-0023 (JP); MIZUNO, Yukitami, Tokyo 105-0023 (JP); SHIBASAKI, Soichiro, Tokyo 105-0023 (JP); WADA, Atsushi, Tokyo 105-0023 (JP); YOSHIO, Sara, Tokyo 105-0023 (JP); TOYOTA, Motohiro, Tokyo 105-0023 (JP); WAKAMATSU, Kodai, Tokyo 105-0023 (JP); NISHIDA, Yasutaka, Tokyo 105-0023 (JP); YAMAMOTO, Kazushige, Tokyo 105-0023 (JP)
(74) Representative: Hoffmann Eitle
(86) International application number: PCT/JP2024/011157
(87) International publication number: WO 2025/197047

(57) **Abstract**

A transparent electrode according to an embodiment includes a compound as a main component including Zn, O and an element denoted by M0. The element denoted by M0 is dispersed in the compound including Zn, O and the element denoted by M0 with sparse-dense distribution in the thickness direction.

## Description

### [Technical Field]

Embodiments described herein relate generally to a transparent electrode, a solar cell, a multi-junction solar cell, a solar cell module, and a photovoltaic power generation system.

### [Background Art]

One of new solar cells is a solar cell using a cuprous oxide (Cu₂O) for a light-absorbing layer. Cu2_{O} is a wide-gap semiconductor. Since Cu₂O is a safe and inexpensive material including copper and oxygen abundantly present on the earth, it is expected that a high-efficiency and low-cost solar cell can be realized.

### [Citation List]

### [Non-Patent Literature]

[Non-Patent Literature 1]
Y. S. Lee et al., Adv. Mater. 26 (2014) 4704.

### [Summary of Invention]

### [Technical Problem]

The problem to be solved by the present invention is to provide a transparent electrode having a low resistance.

### [Solution to Problem]

A transparent electrode according to an embodiment comprises a compound as a main component that includes Zn, O and an element denoted by M0, wherein the element denoted by M0 is dispersed in the compound including Zn, O and the element denoted by M0 has a sparse-dense distribution in the thickness direction.

### [Brief Description of Drawings]

[FIG. 1]

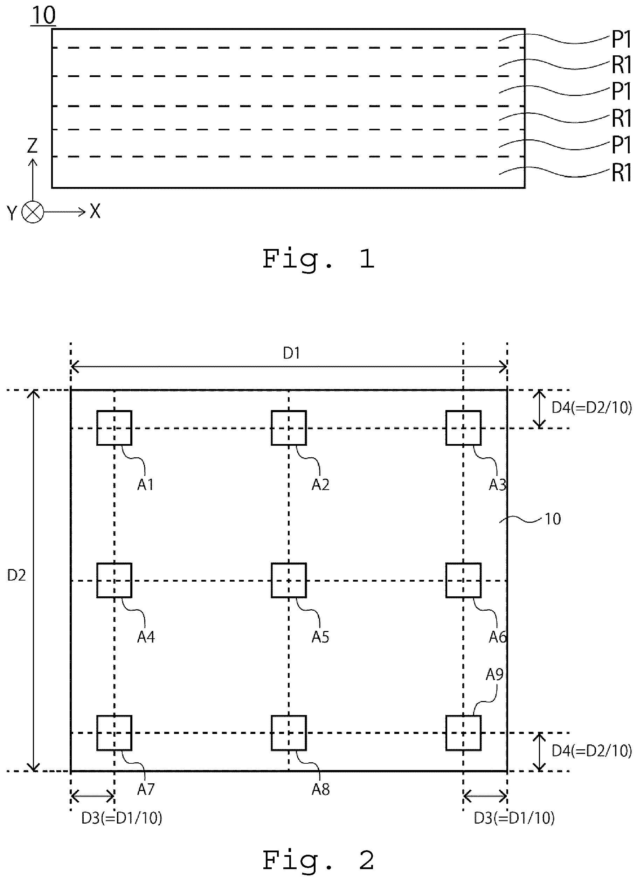

   FIG. 1 is a schematic cross-sectional diagram of a transparent electrode according to an embodiment.
[FIG. 2]
   FIG. 2 is a diagram explaining analysis spots of a transparent electrode according to an embodiment.
[FIG. 3]

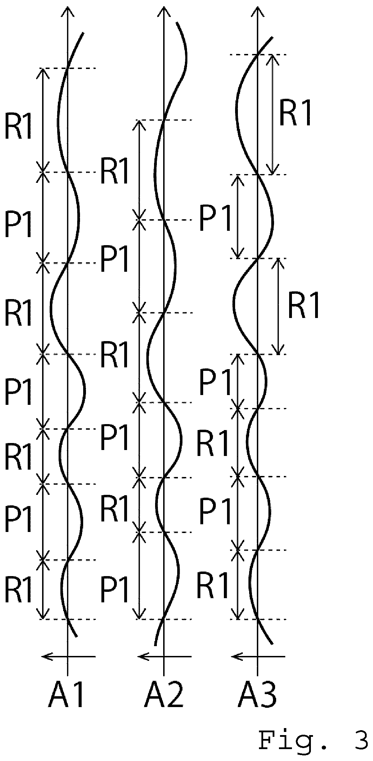

   FIG. 3 is a graph showing concentration of an element denoted by M0 in the thickness direction of a transparent electrode at analysis spots according to an embodiment.
[FIG. 4]

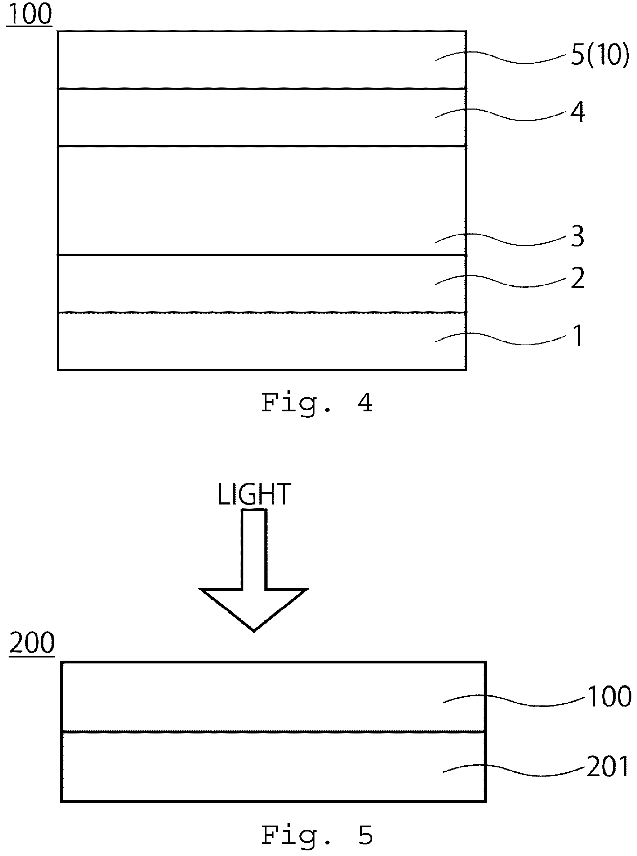

   FIG. 4 is a schematic cross-sectional diagram of a solar cell according to an embodiment.
[FIG. 5]
   FIG. 5 is a cross-sectional diagram of a multi-junction solar cell according to an embodiment.
[FIG. 6]

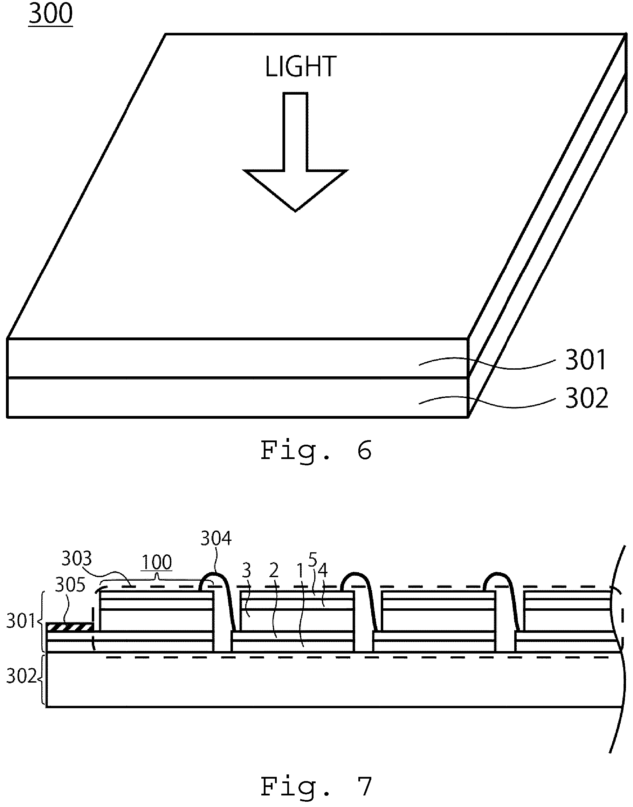

   FIG. 6 is a schematic perspective diagram of a solar cell module according to an embodiment.
[FIG. 7]
   FIG. 7 is a cross-sectional diagram of a solar cell module according to an embodiment.
[FIG. 8]

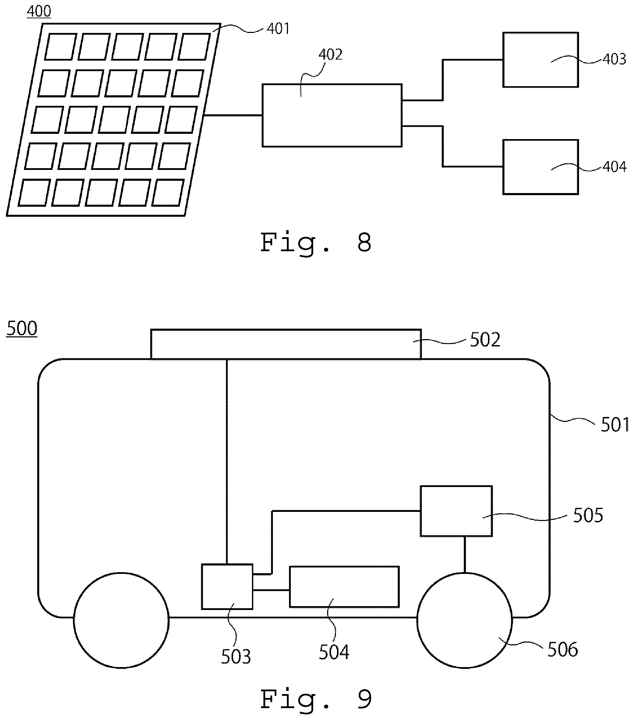

   FIG. 8 is a conceptual diagram of a photovoltaic power generation system according to an embodiment.
[FIG. 9]
   FIG. 9 is a schematic diagram of a vehicle according to an embodiment.
[FIG. 10]

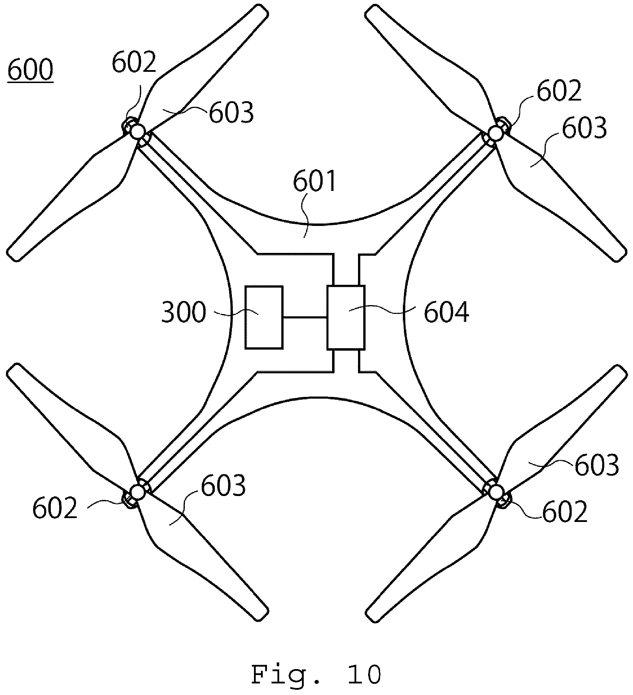

   FIG. 10 is a schematic diagram of a flying object according to an embodiment.
[FIG. 11]

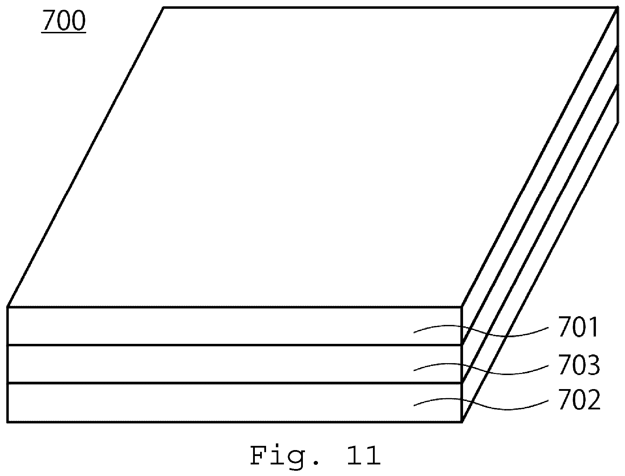

   FIG. 11 is a schematic diagram of a display device according to an embodiment.
[FIG. 12]

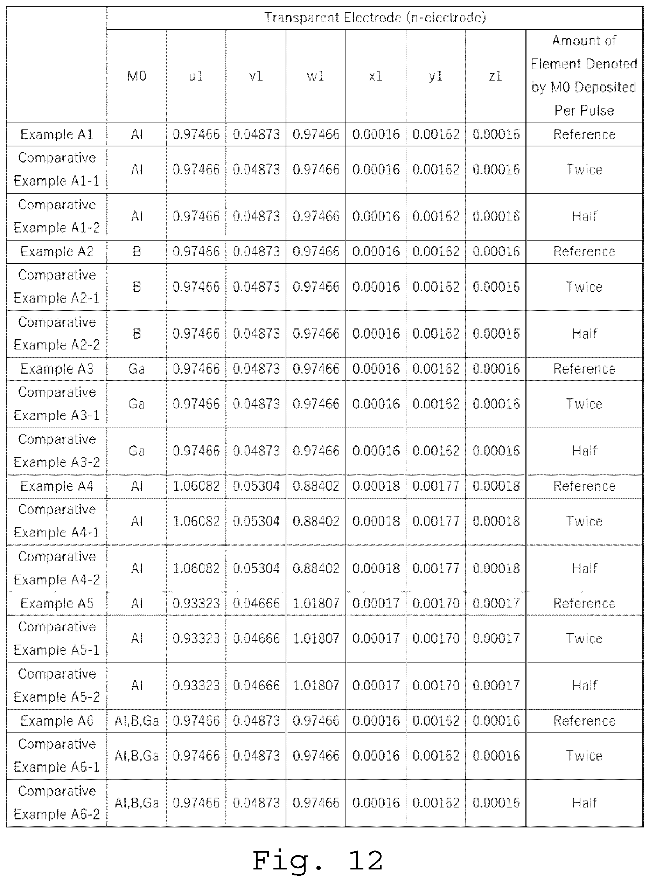

   FIG. 12 is a table relating to examples.
[FIG. 13]

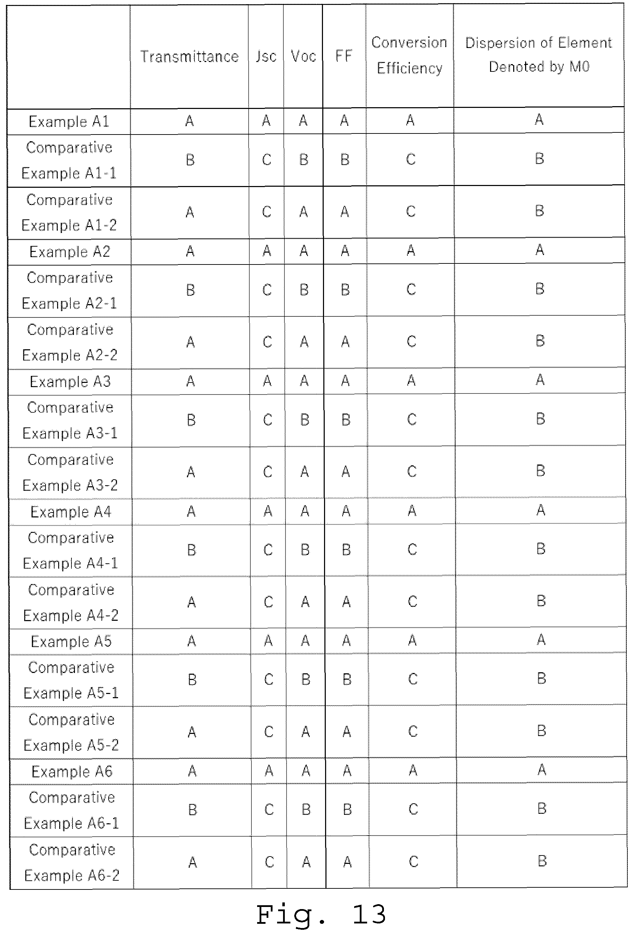

   FIG. 13 is a table relating to examples.
[FIG. 14]

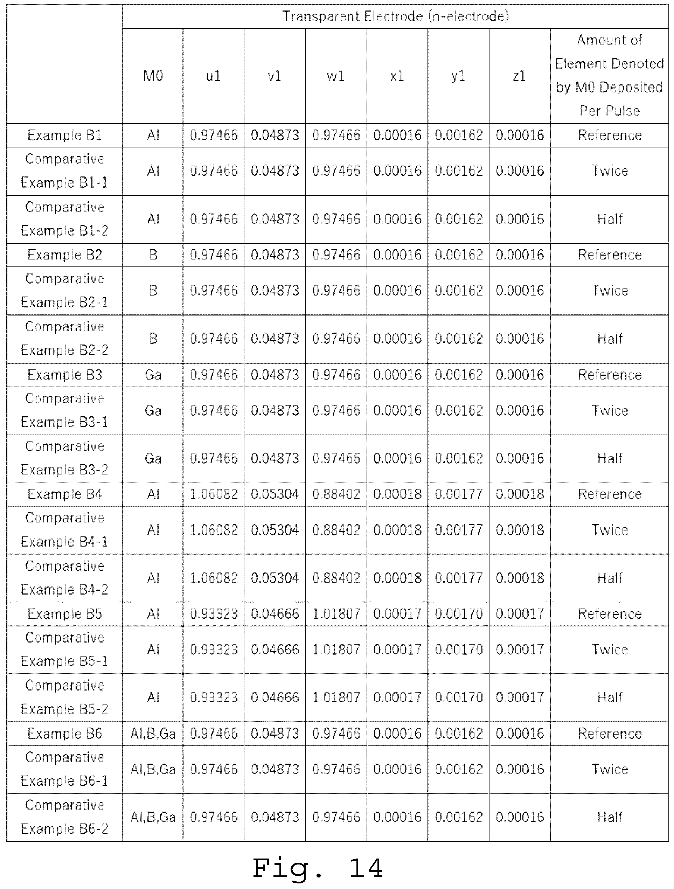

   FIG. 14 is a table relating to examples.
[FIG. 15]

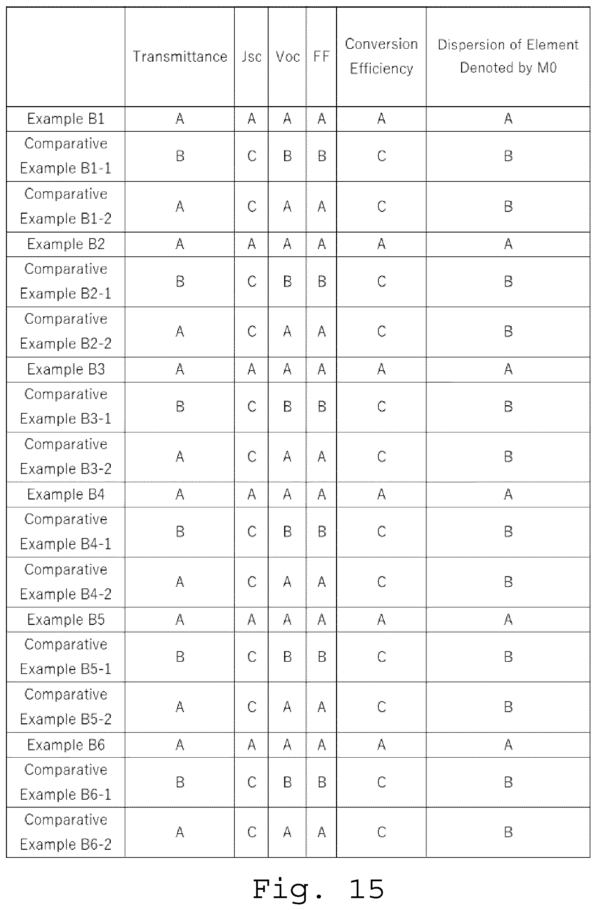

   FIG. 15 is a table relating to examples.

### [Description of Embodiments]

A preferred embodiment of the present invention will be described in detail below with reference to the drawings. Unless otherwise specified, the physical property values are those at 25 °C and 1 atmosphere (atmospheric pressure). The average represents the arithmetic mean value. Each concentration, unless otherwise stated, is the average concentration of the target region or layer. In each layer, the inclusion of a specific element means that its presence has been confirmed by SIMS (Secondary Ion Mass Spectrometry), for example. Conversely, the non-inclusion of a specific element means that it is an element whose presence cannot be confirmed by SIMS (i.e., an element below the detection limit).

In this specification, "/" represents the division symbol. However, "/" in "or/and" means "or". In this specification "·" represents the multiplication symbol. The "." in the numerical values of this specification represents a decimal point.

### (FIRST EMBODIMENT)

A first embodiment relates to a transparent electrode. FIG. 1 shows a schematic cross-sectional diagram of a transparent electrode. The transparent electrode 10 shown in the schematic cross-sectional diagram of FIG. 1 comprises a compound as a main component that includes Zn, O and the element denoted by M0. FIG. 1 is a cross-sectional diagram along the thickness direction of the transparent electrode 10. The transparent electrode 10 is a conductive film that transmits infrared light to visible light. The Z direction is the thickness direction of the transparent electrode 10, and the X-Y plane is the surface direction of the transparent electrode 10.

The thickness of the transparent electrode 10 is preferably 30 nm or more and 150 nm or less, more preferably 30 nm or more and 100 nm or less, and still more preferably 30 nm or more and 50 nm or less. The thickness of the transparent electrode 10 can be determined by cross-sectional observation using an electron microscope or a step profiler.

The compound including Zn, O and the element denoted by M0 comprises Zn, O and the element denoted by M0 as main components. It is preferable that 95 wt% or more and 100 wt% or less of the transparent electrode 10 be the compound including Zn, O and the element denoted by M0; more preferably 98 wt% or more and 100 wt% or less; and even more preferably 99 wt% or more and 100 wt% or less. The transparent electrode 10 can be composed entirely of the compound including Zn, O and the element denoted by M0.

The element(s) denoted by M0 in the compound including Zn, O and the element denoted by M0 are preferably one or more elements selected from the group consisting of Al, B, and Ga. More preferably, the element denoted by M0 is a single element selected from the group consisting of Al, B, and Ga. Preferably, the element denoted by M0 is Al. Alternatively, the element denoted by M0 is preferably B. Alternatively, the element denoted by M0 is preferably Ga.

When the total of all elements included in the compound including Zn, O and the element denoted by M0 is 100 [atom%], the total ratio of Zn, O and the element denoted by M0 included in the compound including Zn, O and the element denoted by M0 is preferably 95 [atom%] or more and 100 [atom%] or less, more preferably 98 [atom%] or more and 100 [atom%] or less, and even more preferably 99 [atom%] or more and 100 [atom%] or less. The ratio of the elements included in the compound including Zn, O and the element denoted by M0 can be determined by analysis using SIMS (Secondary Ion Mass Spectrometry).

It is preferable that the element denoted by M0 in the compound including Zn, O and the element denoted by M0 has a sparse-dense distribution within the transparent electrode 10 along the thickness direction. It is more preferable that the element denoted by M0 has a sparse-dense distribution within the compound including Zn, O and the element denoted by M0 along the thickness direction or/and surface direction of the transparent electrode 10. In other words, the element denoted by M0 in the transparent electrode 10 is not uniformly distributed in the compound including Zn, O and the element denoted by M0, and the concentration does not have an unidirectional gradient. Having a sparse-dense distribution of the element denoted by M0 improves the transmittance of the transparent electrode 10. The presence of the element denoted by M0 with a sparse-dense distribution can be confirmed by analyzing a cross section of the transparent electrode 10 using SEM-EDX (Scanning Electron Microscope-Energy Dispersive X-ray Spectrometry) or STEM-EDX (Scanning Transmission Electron Microscope-Energy Dispersive X-ray Spectrometry).

It is preferable that the element denoted by M0 has an anisotropic distribution within the compound including Zn, O and the element denoted by M0. More preferably, the element denoted by M0 has an anisotropic distribution within the compound including Zn, O and the element denoted by M0 along the thickness direction or/and surface direction of the transparent electrode 10. In other words, the element denoted by M0 in the transparent electrode 10 is not uniformly distributed in the compound including Zn, O and the element denoted by M0, and the concentration does not have an unidirectional gradient. Having an anisotropic distribution of the element denoted by M0 improves the transmittance of the transparent electrode 10. The presence of anisotropy in the distribution of the element denoted by M0 can be confirmed by line analysis using SEM-EDX or STEM-EDX on a cross section of the transparent electrode 10.

It is preferable that the transparent electrode 10 has, in its thickness direction, at least two alternating repetitions each of a first region R1 with a higher ratio of the element denoted by M0 and a second region P1 with a lower ratio of the element denoted by M0. In other words, the element denoted by M0 in the transparent electrode 10 is not uniformly distributed in the compound including Zn, O and the element denoted by M0, and the concentration does not have a unidirectional gradient. The thickness direction of the transparent electrode 10 refers to the distance between the major surface of the transparent electrode 10, which has the largest area, and the surface opposite the major surface.

Preferably, the compound including Zn, O and the element denoted by M0 includes N in addition to Zn, O and the element denoted by M0. Preferably, the compound including Zn, O and the element denoted by M0 includes one or more elements selected from the group consisting of N, C, and H in addition to Zn, O, and the element denoted by M0. Preferably, N, C, and H are included in addition to Zn, O, and the element denoted by M0.

Light transmittance is improved due to including the element denoted by M0. When a relatively large amount of the element denoted by M0 is included, the resistance of the transparent electrode 10 may increase. Therefore, it is preferable that 1 [atom%] or more and 10 [atom%] or less in the transparent electrode 10 is the element denoted by M0; more preferably 2 [atom%] or more and 8 [atom%] or less; and even more preferably 3 [atom%] or more and 6 [atom%] or less.

When the total of all elements included in the compound including Zn, O and the element denoted by M0 is 100 [atom%], the total ratio of Zn, O, N, C, H and the element denoted by M0 included in the compound including Zn, O and the element denoted by M0 is preferably 95 [atom%] or more and 100 [atom%] or less, more preferably 98 [atom%] or more and 100 [atom%] or less, and even more preferably 99 [atom%] or more and 100 [atom%] or less. This ratio can be determined by analysis using SIMS (Secondary Ion Mass Spectrometry).

When the compound including Zn, O and the element denoted by M0 has a relationship of Zn : M0 : O : N : H : C = u1: v1 : w1 : x1 : y1 : z1, it is preferable that u1 + v1 + w1 + x1 + y1 + z1 = 2, 0.95 ≤ (u1 + v1) ≤ 1.15, u1 > 0 and v1 > 0 be satisfied.

When the compound including Zn, O and the element denoted by M0 has the relationship Zn : M0 : O : N : H : C = u1 : v1 : w1 : x1 : y1 : z1, it is preferable that 0.91 ≤ u1 ≤ 1.09, 0.009 ≤ v1 ≤ 0.11, 0.86 ≤ w1 ≤ 1.04, 0.00015 ≤ x1 ≤ 0.0002, 0.0015 ≤ y1 ≤ 0.002, 0.00015 ≤ z1 ≤ 0.0002, 0.95 ≤ (u1 + v1) ≤ 1.15 and 0.0019 ≤ (x1 + y1 + z1) ≤ 0.0022 be satisfied.

When the compound including Zn, O and the element denoted by M0 has the relationship Zn : M0 : O : N : H : C = u1 : v1 : w1 : x1 : y1 : z1, it is more preferable that 0.92 ≤ u1 ≤ 1.08, 0.018 ≤ v1 ≤ 0.085, 0.87 ≤ w1 ≤ 1.04, 0.00016 ≤ x1 ≤ 0.00018, 0.0016 ≤ y1 ≤ 0.0018, 0.00016 ≤ z1 ≤ 0.00018, 0.97 ≤ (u1 + v1) ≤ 1.13 and 0.002 ≤ (x1 + y1 + z1) ≤ 0.00215 be satisfied.

When the compound including Zn, O and the element denoted by M0 has the relationship Zn : M0 : O : N : H : C = u1 : v1 : w1 : x1 : y1 : z1, it is even more preferable that 0.93 ≤ u1 ≤ 1.08, 0.025 ≤ v1 ≤ 0.065, 0.88 ≤ w1 ≤ 1.03, 0.00016 ≤ x1 ≤ 0.00018, 0.0016 ≤ y1 ≤ 0.0018, 0.00016 ≤ z1 ≤ 0.00018, 0.99 ≤ (u1 + v1) ≤ 1.1 and 0.002 ≤ (x1 + y1 + z1) ≤ 0.0021 be satisfied.

Preferably, the compound including Zn, O and the element denoted by M0 is represented by the compound Znᵤ₂M0ᵥ₂O_{w2}Nₓ₂H_{y2}C_{z2} . In the compound Znᵤ₂M0ᵥ₂O_{w2}Nₓ₂H_{y2}C_{z2}, u2, v2, w2, x2, y2, and z2 represent the ratios of the elements in the compound. It is preferable that u2 + v2 + w2 + x2 + y2 + z2 = 2, 0.95 ≤ (u2 + v2) ≤ 1.15, u2 > 0, and v2 > 0 be satisfied.

In the compound represented by Znᵤ₂M0ᵥ₂O_{w2}Nₓ₂H_{y2}C_{z2}, it is preferable that 0.91 ≤ u2 ≤ 1.09, 0.009 ≤ v2 ≤ 0.11, 0.86 ≤ w2 ≤ 1.04, 0.00015 ≤ x2 ≤ 0.0002, 0.0015 ≤ y2 ≤ 0.002, 0.00015 ≤ z2 ≤ 0.0002, 0.95 ≤ (u2 + v2) ≤ 1.15, and 0.0019 ≤ (x2 + y2 + z2) ≤ 0.0022 be satisfied.

In the compound represented by Znᵤ₂M0ᵥ₂O_{w2}Nₓ₂H_{y2}C_{z2}, it is more preferable that 0.92 ≤ u2 ≤ 1.08, 0.018 ≤ v2 ≤ 0.085, 0.87 ≤ w2 ≤ 1.04, 0.00016 ≤ x2 ≤ 0.00018, 0.0016 ≤ y2 ≤ 0.0018, 0.00016 ≤ z2 ≤ 0.00018, 0.97 ≤ (u2 + v2) ≤ 1.13, and 0.002 ≤ (x2 + y2 + z2) ≤ 0.00215 be satisfied.

In the compound represented by Znᵤ₂M0ᵥ₂O_{w2}Nₓ₂H_{y2}C_{z2}, it is even more preferably 0.93 ≤ u2 ≤ 1.08, 0.025 ≤ v2 ≤ 0.065, 0.88 ≤ w2 ≤ 1.03, 0.00016 ≤ x2 ≤ 0.00018, 0.0016 ≤ y2 ≤ 0.0018, 0.00016 ≤ z2 ≤ 0.00018, 0.99 ≤ (u2 + v2) ≤ 1.1, and 0.002 ≤ (x2 + y2 + z2) ≤ 0.0021 be satisfied.

ZnO doped with the element denoted by M0 is used as a conductive transparent electrode. It is preferable that the element denoted by M0 is distributed anisotropically in the thickness direction of the transparent electrode 10. From the viewpoint of obtaining a low-resistance transparent electrode 10, it is preferable that regions with a higher ratio of the element denoted by M0 (the first region R1) and regions with a lower ratio of the element denoted by M0 (the second region P1) alternately exist.

It is considered that the element denoted by M0 binds more strongly to O than Zn and induces oxygen vacancies, thereby generating carriers. From the viewpoint of improving the conductivity of the transparent electrode 10, it is preferable that the element denoted by M0 is distributed anisotropically in the thickness direction of the transparent electrode 10 rather than being uniformly dispersed or having a simple gradient change in concentration in the thickness direction.

It is preferable that regions with a higher ratio of the element denoted by M0 (the first region R1) and regions with a lower ratio of the element denoted by M0 (the second region P1) alternately exist twice or more in the thickness direction of the transparent electrode 10. It is preferable that the range where a higher ratio of the element denoted by M0 (the first region R1) and regions with a lower ratio of the element denoted by M0 (the second region P1) alternately exist twice or more in the thickness direction of the transparent electrode 10 is 80% or more and 100% or less of the thickness of the transparent electrode 10. It is preferable that the regions with a higher ratio of the element denoted by M0 (the first region R1) and the regions with a lower ratio of the element denoted by M0 (the second region P1) repeat overall in an alternating manner throughout the thickness direction of the transparent electrode 10.

It is preferable that the amount of the element denoted by M0 in the first region R1 be 3 [atom%] or more and 10 [atom%] or less; more preferably 4 [atom%] or more and 8 [atom%] or less; and even more preferably 5 [atom%] or more and 7 [atom%] or less.

It is preferable that 1 [atom%] or more and 8 [atom%] or less of the element denoted by M0 be in the second region P1; more preferably 2 [atom%] or more and 6 [atom%] or less; and even more preferably, 3 [atom%] or more and 5 [atom%] or less.

In the first region R1 with a higher ratio of the element denoted by M0, the relationship Zn : M0 : O : N : H : C = u3 : v3 : w3 : x3 : y3 : z3 is present. In the second region P1 with a lower ratio of the element denoted by M0, the relationship Zn : M0 : O : N : H : C = u4 : v4 : w4 : x4 : y4 : z4 is present.

In the first region R1 with a higher ratio of the element denoted by M0, the relationship Zn : M0 : O : N : H : C = u3 : v3 : w3 : x3 : y3 : z3 is present; and u3 + v3 + w3 + x3 + y3 + z3 = 2 is satisfied, in the second region P1 with a lower ratio of the element denoted by M0, the relationship Zn : M0 : O : N : H : C = u4 : v4 : w4 : x4 : y4 : z4 is present; and u4 + v4 + w4 + x4 + y4 + z4 = 2, and it is preferable that u3 be 0.971 times or more and 0.995 times or less of u4; more preferably 0.981 times or more and 0.995 times or less of u4; and even more preferably 0.985 times or more and 0.990 times or less of u4. Furthermore, it is preferable that v3 be 1.194 times or more and 3.885 times or less of v4; more preferably 1.244 times or more and 2.942 times or less of v4; and even more preferably 1.485 times or more and 1.971 times or less of v4. Furthermore, it is preferable that w3 be 0.971 times or more and 0.995 times or less of w4. Furthermore, it is preferable that x3 be 0.971 times or more and 0.995 times or less of x4. Furthermore, it is preferable that y3 be 0.971 times or more and 0.995 times or less of y4. Furthermore, it is preferable that z3 be 0.971 times or more and 0.995 times or less of z4. Furthermore, it is preferable that u3 be 0.986 times or more and 0.995 times or less of u1. Furthermore, it is preferable that v3 be 1.194 times or more and 1.577 times or less of v1. Furthermore, it is preferable that w3 be 0.986 times or more and 0.995 times or less of w1. Furthermore, it is preferable that x3 be 0.986 times or more and 0.995 times or less of x1. Furthermore, it is preferable that y3 be 0.986 times or more and 0.995 times or less of y1. Furthermore, it is preferable that z3 be 0.986 times or more and 0.995 times or less of z1. Furthermore, it is preferable that u4 be 1.000 times or more and 1.015 times or less of u1. Furthermore, it is preferable that v4 be 0.406 times or more and 1.000 times or less of v1. Furthermore, it is preferable that w4 be 1.000 times or more and 1.015 times or less of w1. Furthermore, it is preferable that x4 be 1.000 times or more and 1.015 times or less of x1. Furthermore, it is preferable that y4 be 1.000 times or more and 1.015 times or less of y1. Furthermore, it is preferable that z4 be 1.000 times or more and 1.015 times or less of z1.

In the first region R1 with a higher ratio of the element denoted by M0, the compound including Zn, the element denoted by M0 is represented by Znᵤ₅M0ᵥ₅C_{w5}Nₓ₅H_{y5}O_{w5}; the relationship Zn : M0 : O : N : H : C = u5 : v5 : w5 : x5 : y5 : z5 is present; and u5 + v5 + w5 + x5 + y5 + z5 = 2, in the second region P1 with a lower ratio of the element denoted by M0, the compound including Zn, O and the element denoted by M0 is represented by Znᵤ₆M0ᵥ₆C_{w6}Nₓ₆H_{y6}O_{w6}; the relationship Zn : M0 : O : N : H : C = u6 : v6 : w6 : x6 : y6 : z6 is present; and u6 + v6 + w6 + x6 + y6 + z6 = 2, and it is preferable that u5 is 0.971 times or more and 0.995 times or less of u6; more preferably 0.981 times or more and 0.995 times or less of u6; and even more preferably 0.985 times or more and 0.990 times or less of u6. Furthermore, it is preferable that v5 be 1.194 times or more and 3.885 times or less of v6; more preferably 1.244 times or more and 2.942 times or less of v6; and even more preferably 1.485 times or more and 1.971 times or less of v6. Furthermore, it is preferable that w5 be 0.971 times or more and 0.995 times or less of w6. Furthermore, it is preferable that x5 be 0.971 times or more and 0.995 times or less of x6. Furthermore, it is preferable that y5 be 0.971 times or more and 0.995 times or less of y6. Furthermore, it is preferable that z5 be 0.971 times or more and 0.995 times or less of z6. Furthermore, it is preferable that u5 be 0.986 times or more and 0.995 times or less of u2. Furthermore, it is preferable that v5 be 1.194 times or more and 1.577 times or less of v2. Furthermore, it is preferable that w5 be 0.986 times or more and 0.995 times or less of w2. Furthermore, it is preferable that x5 be 0.986 times or more and 0.995 times or less of x2. Furthermore, it is preferable that y5 be 0.986 times or more and 0.995 times or less of y2. Furthermore, it is preferable that z5 be 0.986 times or more and 0.995 times or less of z2. Furthermore, it is preferable that u6 be 1 times or more and 1.015 times or less of u2. Furthermore, it is preferable that v6 be 0.406 times or more and 1.000 times or less of v2. Furthermore, it is preferable that w6 be 1 times or more and 1.015 times or less of w2. Furthermore, it is preferable that x6 be 1 times or more and 1.015 times or less of x2. Furthermore, it is preferable that y6 be 1 times or more and 1.015 times or less of y2. Furthermore, it is preferable that z6 be 1 times or more and 1.015 times or less of z2.

From the viewpoint of reducing the resistance of the transparent electrode 10, it is preferable that the thickness of the first region R1 be 0.4 [nm] or more and 1 [nm] or less, and it is preferable that the thickness of the second region P1 be 0.4 [nm] or more and 1 [nm] or less. From the same viewpoint, it is more preferable that the thickness of the first region R1 be 0.5 [nm] or more and 0.9 [nm] or less, and it is more preferable that the thickness of the second region P1 be 0.5 [nm] or more and 0.9 [nm] or less. From the same viewpoint, it is even more preferable that the thickness of the first region R1 be 0.5 [nm] or more and 0.8 [nm] or less, and it is even more preferable that the thickness of the second region P1 be 0.5 [nm] or more and 0.8 [nm] or less.

The relationship between the first region R1 and the second region P1 can be confirmed, for example, by analyzing analysis spots A1 to A9 shown in FIG. 2. D1 is the length of the transparent electrode 10 in the width direction (X direction). D2 is the length of the transparent electrode 10 in the length direction (Y direction). Note that at any specific depth position from the surface of the transparent electrode, a configuration that A1 to A9 are all the first region R1 or the second region P1, and a configuration that A1 to A9 are independently the first region R1 or the second region P1 are included. For example, when a specific depth position of the center A5 of the transparent electrode 10 is the first region R1, the first region R1 at that specific depth position of the center A5 of the transparent electrode 10 is sandwiched by the second regions P1 in the thickness direction of the transparent electrode 10. In other words, when analyzing the transparent electrode 10 in the depth direction from any surface point of the transparent electrode 10, it is preferable that the first region R1 and the second region P1 be repeated within the range where the first region R1 and the second region P1 exist alternately-and-repeatedly more than twice. It is preferable to confirm that the first region R1 and the second region P1 are repeated by analyzing a cross section of the transparent electrode 10 in the depth direction from any surface point of the transparent electrode 10. When analyzing a cross section of the transparent electrode 10 with HAADF-STEM (High-Angle Annular Dark Field Scanning TEM), it is possible to confirm that the first region R1 and the second region P1 are alternately repeated more than twice in the thickness direction of the transparent electrode 10 by checking the pattern of brightness and darkness difference in the image. In addition, by analyzing a cross section of the transparent electrode 10 with SEM-EDX or TEM-EDX, it is possible to confirm that the first region R1 and the second region P1 are alternately repeated more than twice in the thickness direction of the transparent electrode 10. When analyzed by EDX, the beam diameter is preferably 0.1 nm or more and 5 nm or less; the analysis depth is preferably the thickness of the sample thin slice.

FIG. 3 schematically illustrates a graph showing the concentration of the element denoted by M0 in the thickness direction of the transparent electrode 10 at analysis spots A1 to A9, among which A1 to A3 are shown as examples. The vertical axis represents the depth direction. The horizontal axis represents the concentration of the element denoted by M0 (higher concentration at the tip of the arrow). The concentration of the element denoted by M0 at the intersection of the vertical and horizontal axes is represented by v1.

The concentration of the element denoted by M0 preferably changes periodically in the thickness direction. The phase of the periodic change in the concentration of the element denoted by M0 may be shifted depending on the position of the transparent electrode 10. It is preferable that one cycle (sum of the average thicknesses of the first region R1 and the second region P1) of the concentration change of the element denoted by M0 in the thickness direction of the transparent electrode 10 be 0.8 [nm] or more and 2 [nm] or less. This contributes to reducing the resistance of the transparent electrode 10. From the same viewpoint, it is more preferable that one cycle of the concentration change of the element denoted by M0 in the thickness direction of the transparent electrode 10 be 1 [nm] or more and 1.8 [nm] or less; and even more preferably 1 [nm] or more and 1.6 [nm] or less.

The boundary between the first region R1 and the second region P1 is a position where the concentration of the element denoted by M0 satisfies v1.

Preferably, the transparent electrode 10 has a third region R2 with a higher ratio of the element denoted by M0 and a fourth region P2 with a lower ratio of the element denoted by M0 in the surface direction. It is preferable that multiple third regions R2 and multiple fourth regions P4 exist in the surface direction of the transparent electrode 10. It is preferable that within the range where the first region R1 and the second region P1 repeatedly exist more than twice alternately in the thickness direction of the transparent electrode 10, the third region R2 with a higher ratio of the element denoted by M0 and the fourth region P2 with a lower ratio of the element denoted by M0 exist in the surface direction.

It is preferable that the range (area in the surface direction of the transparent electrode 10) where the third region R2 and the fourth region P2 exist alternately in the surface direction of the transparent electrode 10 be 5% or more and 30% or less of the area (cross-sectional area in the surface direction of the transparent electrode 10) of the transparent electrode 10 within the range where the first region R1 and the second region P1 repeatedly exist more than twice alternately in the thickness direction of the transparent electrode 10.

It is preferable that the concentration of the element denoted by M0 in the third region R2 be 3 [atom%] or more and 10 [atom%] or less; more preferably 4 [atom%] or more and 8 [atom%] or less; and even more preferably 5 [atom%] or more and 7 [atom%] or less.

It is preferable that the concentration of the element denoted by M0 in the fourth region P2 be 1 [atom%] or more and 8 [atom%] or less; more preferably 2 [atom%] or more and 6 [atom%] or less; and even more preferably 3 [atom%] or more and 5 [atom%] or less.

In the third region R2 with a higher ratio of the element denoted by M0, the relationship Zn : M0 : O : N : H : C = u7 : v7 : w7 : x7 : y7 : z7 is present, and in the fourth region P2 with a lower ratio of the element denoted by M0, the relationship Zn : M0 : O : N : H : C = u8 : v8 : w8 : x8 : y8 : z8 is present.

In the third region R2 with a higher ratio of the element denoted by M0, the relationship Zn : M0 : O : N : H : C = u7 : v7 : w7 : x7 : y7 : z7 is present; and u7 + v7 + w7 + x7 + y7 + z7 = 2 is satisfied, in the fourth region P2 with a lower ratio of the element denoted by M0, the relationship Zn : M0 : O : N : H : C = u8 : v8 : w8 : x8 : y8 : z8 is present; and u8 + v8 + w8 + x8 + y8 + z8 = 2 is satisfied, it is preferable that u7 be 0.971 times or more and 0.995 times or less of u8; more preferably 0.981 times or more and 0.995 times or less of u8; and even more preferably 0.985 times or more and 0.990 times or less of u8, and it is preferable that v7 be 1.194 times or more and 3.885 times or less of v8; more preferably 1.244 times or more and 2.942 times or less of v8; and even more preferably 1.485 times or more and 1.971 times or less of v8. Furthermore, it is preferable that w7 be 0.971 times or more and 0.995 times or less of w8. Furthermore, it is preferable that x7 be 0.971 times or more and 0.995 times or less of x8. Furthermore, it is preferable that y7 be 0.971 times or more and 0.995 times or less of y8. Furthermore, it is preferable that z7 be 0.971 times or more and 0.995 times or less of z8. Furthermore, it is preferable that u7 be 0.986 times or more and 0.995 times or less of u1. Furthermore, it is preferable that v7 be 1.194 times or more and 1.577 times or less of v1. Furthermore, it is preferable that w7 be 0.986 times or more and 0.995 times or less of w1. Furthermore, it is preferable that x7 be 0.986 times or more and 0.995 times or less of x1. Furthermore, it is preferable that y7 be 0.986 times or more and 0.995 times or less of y1. Furthermore, it is preferable that z7 be 0.986 times or more and 0.995 times or less of z1. Furthermore, it is preferable that u8 be 1 times or more and 1.015 times or less of u1. Furthermore, it is preferable that v8 be 0.406 times or more and 1 times or less of v1. Furthermore, it is preferable that w8 be 1 times or more and 1.015 times or less of w1. Furthermore, it is preferable that x8 be 1 times or more and 1.015 times or less of x1. Furthermore, it is preferable that y8 be 1 times or more and 1.015 times or less of y1. Furthermore, it is preferable that z8 be 1 times or more and 1.015 times or less of z1.

In the third region R2 with a higher ratio of the element denoted by M0, the compound including Zn, O, the element denoted by M0 is represented by Znᵤ₉M0ᵥ₉O_{w9}Nₓ₉H_{y9}C_{z9}; the relationship Zn : M0 : O : N : H : C = u9 : v9 : w9 : x9 : y9 : z9 is present; and u9 + v9 + w9 + x9 + y9 + z9 = 2 is satisfied, in the fourth region P2 with a lower ratio of the element denoted by M0, the compound including Zn, O, and the element denoted by M0 is represented by Zn u10 M0 v10 O w10 N x10 H y10 C z10; relationship Zn : M0 : O : N : H : C = u10 : v10 : w10 : x10 : y10 : z10 is present, u10 + v10 + w10 + x10 + y10 + z10 = 2 is satisfied, it is preferable that u9 be 0.971 times or more and 0.995 times or less of u10; more preferably 0.981 times or more and 0.995 times or less of u10; and even more preferably 0.985 times or more and 0.990 times or less of u10, it is preferable that v9 be 1.194 times or more and 3.885 times or less of v10; more preferably 1.244 times or more and 2.942 times or less of v10; and even more preferably 1.485 times or more and 1.971 times or less of v10. Furthermore, it is preferable that w9 be 0.971 times or more and 0.995 times or less of w10. Furthermore, it is preferable that x9 be 0.971 times or more and 0.995 times or less of x10. Furthermore, it is preferable that y9 be 0.971 times or more and 0.995 times or less of y10. Furthermore, it is preferable that z9 be 0.971 times or more and 0.995 times or less of z10. Furthermore, it is preferable that u9 be 0.986 times or more and 0.995 times or less of u2. Furthermore, it is preferable that v9 be 1.194 times or more and 1.577 times or less of v2. Furthermore, it is preferable that w9 be 0.986 times or more and 0.995 times or less of w2. Furthermore, it is preferable that x9 be 0.986 times or more and 0.995 times or less of x2. Furthermore, it is preferable that y9 be 0.986 times or more and 0.995 times or less of y2. Furthermore, it is preferable that z9 be 0.986 times or more and 0.995 times or less of z2. Furthermore, it is preferable that u10 be 1 times or more and 1.015 times or less of u2. Furthermore, it is preferable that v10 be 0.406 times or more and 1 times or less of v2. Furthermore, it is preferable that w10 be 1 times or more and 1.015 times or less of w2. Furthermore, it is preferable that x10 be 1 times or more and 1.015 times or less of x2. Furthermore, it is preferable that y10 be 1 times or more and 1.015 times or less of y2. Furthermore, it is preferable that z10 be 1 times or more and 1.015 times or less of z2.

From the viewpoint of reducing the resistance of the transparent electrode 10, it is preferable that the length (width in the surface direction) of the third region R2 be 0.4 nm or more and 1 nm or less, and it is preferable that the length (width in the surface direction) of the fourth region P2 be 0.4 [nm] or more and 1 [nm] or less. From the same viewpoint, it is more preferable that the length of the third region R2 be 0.5 [nm] or more and 0.9 [nm] or less, and it is more preferable that the length of the fourth region P2 be 0.5 [nm] or more and 0.9 [nm] or less. From the same viewpoint, it is more preferable that the length of the third region R2 be 0.5 [nm] or more and 0.8 [nm] or less, and it is more preferable that the length of the fourth region P2 be 0.5 [nm] or more and 0.8 [nm] or less.

The relationship between the third region R2 and the fourth region P2 can be confirmed by analyzing a cross-section in the surface direction of the transparent electrode 10 using SEM-EDX or TEM-EDX. For example, the third region R2 and the fourth region P2 can be confirmed by evaluating the difference in the concentration of the element denoted by M0 at each spot A1 to A9 shown in FIG. 2, which are analyzed. The analysis method for the third region R2 and the fourth region P2 is performed, for example, by evaluating the fluctuation in the concentration of the element denoted by M0 at analysis spots A1 to A9 at the same depth, as in the analysis of the first region R1 and the second region P1.

Next, a method manufacturing of the transparent electrode 10 will be described. The transparent electrode 10 is formed on a base member. The base member, for example, is a solar cell where one electrode is not provided. More specifically, a transparent electrode is formed on the n-type layer of a solar cell. In addition to the solar cell, the transparent electrode 10 can also be used as an electrode for display panels and the like.

The transparent electrode 10 is preferably manufactured by ALD (Atomic Layer Deposition). An organic zinc compound and an organic compound including the element denoted by M0 are supplied as precursors to a chamber, and the transparent electrode 10 is formed on the base member. The embodiment's transparent electrode 10 can be obtained by reducing the amount of the element denoted by M0 deposited per pulse without repeatedly increasing and decreasing the deposited amount. By reducing the amount of the element denoted by M0 deposited per pulse, the concentration of the element denoted by M0 in the transparent electrode 10 does not become high, and the transparent electrode 10 where the element denoted by M0 is distributed at a suitable distance can be obtained. This transparent electrode 10 can achieve both low resistance and high transparency. By reducing the amount of the element denoted by M0 deposited per pulse, the embodiment's transparent electrode 10 can be obtained.

As an organic zinc compound, one or more compounds selected from the group consisting of dimethylzinc, diethylzinc, etc., are preferable.

As an organic compound including the element denoted by M0, one or more selected from the group consisting of trimethylaluminum, triethylaluminum, trisdimethylamidoaluminum, trimethylgallium, trisdimethylamidogallium, trimethylboron, triethylboron, and trisdimethylamidoboron are preferable. From the viewpoint of obtaining the embodiment's transparent electrode 10, it is preferable that the organic compound including the element denoted by M0 includes nitrogen.

From the viewpoint of manufacturing a transparent electrode 10 where the first region R1 and the second region P1 are alternately repeated, it is preferable that the ratio of the element denoted by M0 to nitrogen atoms in the organic compound including the element denoted by M0 ([number of moles of the element denoted by M0 in the organic compound] / [number of moles of nitrogen atoms in the organic compound]) be 0.3 or more and 1 or less; and more preferably 0.5 or more and 1 or less.

From the viewpoint of manufacturing a transparent electrode 10 where the first region R1 and the second region P1 are alternately repeated, it is preferable to manufacture it using ALD. When sputtering is used to manufacture the transparent electrode 10, a highly uniform transparent electrode with no alternating repetition of the first region R1 and the second region P1 is obtained.

The transparent electrode 10 where the first region R1 and the second region P1 are repeated twice or more has a high light transmittance of 80% or more for light with a wavelength of 400 nm or more and 1300 nm or less. The transparent electrode 10, where the first region R1 and the second region P1 are repeated twice or more, shows improved transmittance for light with a wavelength of approximately 300 nm or more and approximately 1100 nm or less. This embodiment's transparent electrode 10 is a conductive film that achieves both low resistivity and light transmittance. Therefore, it is suitably used as a transparent electrode for devices such as solar cells and displays, where high visible light transmittance is required.

### (SECOND EMBODIMENT)

A second embodiment relates to a solar cell. FIG. 4 shows a cross-sectional diagram of a solar cell 100 according to this embodiment. As shown in FIG. 4, the solar cell 100 comprises a substrate 1, a first electrode (p-electrode) 2, a p-type light absorbing layer 3, an n-type layer 4, and a second electrode (n-electrode) 5. An intermediate layer (not shown) may be included between the n-type layer 4 and the n-electrode 5. Sunlight can enter from either the n-electrode 5 side or the p-electrode 2 side, but it is preferable for sunlight to enter from the n-electrode 5 side. Since the solar cell 100 of this embodiment is a transparent type solar cell, it is preferably used on the top cell side (light incident side) of a multi-junction solar cell. In FIG. 4, the substrate 1 is shown on the opposite side of the p-type light absorbing layer 3, but it may also be placed on the opposite side of the n-type layer 4 with respect to the n-electrode 5. The following description will focus on the form shown in FIG. 6, but the configuration where the substrate 1 is positioned on the n-electrode 5 side is essentially the same. In the solar cell 100 of this embodiment, light enters from the n-electrode 5 side and travels towards the p-electrode 2 side.

The solar cell 100 of this embodiment uses transparent electrodes for both the p-electrode 2 and the n-electrode 5. This results in a high transmittance for light in the wavelength range of 700 nm or more and 1200 nm or less, leading to a red (reddish brown), yellow, or orange transparent solar cell.

The substrate 1 is a transparent substrate. Suitable materials for the substrate 1 include: transparent organic substrates such as acrylic, polyimide, polycarbonate, polyethylene terephthalate (PET), polypropylene (PP), fluorine-based resins (polytetrafluoroethylene (PTFE), fluoroethylene propylene copolymer (FEP), ethylene tetrafluoroethylene copolymer (ETFE), polychlorotrifluoroethylene (PCTFE), perfluoroalkoxy alkane (PFA)), polyarylate, polysulfone, polyethersulfone or polyetherimide; and inorganic substrates such as soda-lime glass, ultra clear glass, chemically strengthened glass, or quartz. The substrate 1 may be a laminate of the aforementioned substrates.

The p-electrode 2 is located on the substrate 1 and positioned between the substrate 1 and the p-type light absorbing layer 3. It is preferable for the p-electrode 2 to form an ohmic junction with the p-type light absorbing layer 3. The p-electrode 2 is a conductive layer having light transmittance provided on the p-type light absorbing layer 3 side. The thickness of the p-electrode 2 is typically 100 nm or more and 2000 nm or less. In FIG. 4, the p-electrode 2 is in direct contact with the p-type light absorbing layer 3. The p-electrode 2 preferably includes one or more layers of transparent conductive oxide film. Examples of transparent conductive oxide films include: Indium Tin Oxide (ITO) Aluminum-doped Zinc Oxide (AZO), Boron-doped Zinc Oxide (BZO), Gallium-doped Zinc Oxide (GZO), doped tin oxide, Titanium-doped Indium Oxide (ITO), Indium Zinc Oxide (IZO) and Indium Gallium Zinc Oxide (IGZO), Hydrogen-doped Indium Oxide (IHO), and these are not particularly limited. The transparent conductive oxide film may be a multilayer laminated film. As for the dopant in the film, such as tin oxide, one or more elements selected from the group consisting of In, Si, Ge, Ti, Cu, Sb, Nb, Ta, W, Mo, F and Cl are not particularly limited. The p-electrode 2 preferably includes a doped tin oxide film doped with one or more elements selected from the group consisting of In, Si, Ge, Ti, Cu, Sb, Nb, Ta, W, Mo, F and Cl. In the doped tin oxide film, one or more elements selected from the group consisting of In, Si, Ge, Ti, Cu, Sb, Nb, Ta, W, Mo, F and Cl are preferably included at 10 atomic % or less with respect to the tin included in the tin oxide film. As for the p-electrode 2, a laminated film consisting of a transparent conductive oxide film and a metal film can be used. The metal film is preferably 1 [nm] or more and 2 [µm] or less in thickness. As for the metal included in the metal film (including alloys), Mo, Au, Cu, Ag, Al, Ta and W are not particularly limited. The p-electrode 2 may further include a dot-shaped, line-shaped or mesh-shaped electrode (selected from one or more of metals, alloys, graphene, conductive nitrides and conductive oxides) between the transparent conductive oxide film and the substrate 1, or between the transparent conductive oxide film and the p-type light absorbing layer 3. The dot-shaped, line-shaped or mesh-shaped metal is preferably 50% or more in terms of aperture ratio with respect to the transparent conductive oxide film. The dot-shaped, line-shaped or mesh-shaped metal is not particularly limited to Mo, Au, Cu, Ag, Al, Ta and W. When a metal film is used for the p-electrode 2, a film thickness of about 5 [nm] or less is preferable from the viewpoint of transmittance. In the case of using a line-shaped or mesh-shaped metal film, since the transmittance is secured by the openings, the limitation of the film thickness is not for the metal film.

It is preferable for a doped tin oxide film, which forms an ohmic junction with the p-type light-absorbing layer 3, to be provided on the outermost surface of the p-type light-absorbing layer 3 side of the transparent conductive oxide film. It is further preferable that at least a portion of the doped tin oxide film provided on the p-type light-absorbing layer 3 side of the transparent conductive oxide film is in direct contact with the p-type light-absorbing layer 3.

The p-type light-absorbing layer 3 is a p-type semiconductor layer. The p-type light-absorbing layer 3 is provided on the p-electrode 2. The p-type light-absorbing layer 3 may be in direct contact with the p-electrode 2, or other layers may exist as long as electrical contact between the p-electrode 2 and the p-type light-absorbing layer 3 can be ensured. The p-type light-absorbing layer 3 is positioned between the p-electrode 2 and the n-type layer 4. Only a portion of the surface but not entire surface of the p-type light-absorbing layer 3 facing the n-type layer 4 is in direct contact with the n-type layer 4. The p-type light-absorbing layer 3 is primarily composed of a cuprous oxide compound. It is preferable for the cuprous oxide compound to have a chalcopyrite structure.

The p-type light-absorbing layer 3 is preferably a semiconductor layer comprising a cuprous oxide compound. The p-type light-absorbing layer 3 is preferably polycrystalline. A small amount of impurities in the form of one or more of copper (Cu), copper oxide (CuO), and copper hydroxide (Cu(OH)₂) may be included in the p-type light-absorbing layer 3.

When all elements other than oxygen are considered to be 100% in the p-type light-absorbing layer 3, it is preferable that the copper content be 90% or more and 100% or less; more preferably 95% or more and 100% or less; even more preferably 98% or more and 100% or less; and most preferably 99% or more and 100% or less.

When the cuprous oxide compound includes elements other than copper and oxygen, when all elements other than oxygen are considered to be 100% in the p-type light-absorbing layer 3, the copper content is preferably 90.0% or more and 99.9% or less; more preferably 95.0% or more and 99.9% or less; even more preferably 98% or more and 99.9% or less; and most preferably 99.0% or more and 99.9% or less.

The cuprous oxide compound preferably includes copper, oxygen, and optionally an element represented by M1. The element represented by M1 is preferably one or more elements selected from the group consisting of Cl, F, Br, I, Sn, Sb, Ag, Li, Na, K, Cs, Rb, Al, In, Zn, Mg, Ga, Si, Ge, N, P, B, Ti, Hf, Zr and Ca.

When all elements other than oxygen are considered to be 100% in the p-type light-absorbing layer 3, the total amount of copper and the element represented by M1 is preferably 95% or more and 100% or less; more preferably 98% or more and 100% or less; and most preferably 99% or more and 100% or less.

The amount of oxygen atoms in the cuprous oxide compound is preferably 0.48 or more and 0.56 or less when the amount of copper atoms is set to 1. When there is too much oxygen compared to copper, the ratio of copper oxide in the cuprous oxide compound increases, leading to a narrower band gap and reduced transmittance of the p-type light absorbing layer 3. Conversely, when the ratio of copper to oxygen is too high, the transmittance will be reduced due to the increased amount of copper in the cuprous oxide compound. In addition, when the ratio of oxygen to copper does not fall within the aforementioned range, it becomes difficult for the cuprous oxide compound to have a chalcopyrite structure.

It is preferable for 95 [wt%] or more and 100 [wt%] or less of the p-type light-absorbing layer 3 to be a cuprous oxide compound; more preferably 98 [wt%] or more and 100 [wt%] or less to be a cuprous oxide compound; and even more preferably 99 [wt%] or more and 100 [wt%] or less to be a cuprous oxide compound. The p-type light-absorbing layer 3 can be composed entirely of a cuprous oxide compound.

When the p-type light-absorbing layer 3 has fewer defects and good crystallinity, its transmittance is improved, which is desirable. The band gap of the p-type light-absorbing layer 3 can be adjusted by incorporating elements other than Cu and O. A band gap of 2.0 [eV] or more and 2.2 [eV] or less is preferable for the p-type light-absorbing layer 3. Within this range, both top and bottom cells can efficiently utilize sunlight in multi-junction solar cells with the embodiment's solar cell as a top cell and a silicon-based solar cell as a bottom cell. It is preferable for the p-type light-absorbing layer 3 to include Sn or/and Sb. The Sn and Sb in the p-type light-absorbing layer 3 may be added, or they may originate from the p-electrode 2. Ga included in the p-type light-absorbing layer 3 is not a component of the material used to form the p-type light-absorbing layer 3 itself but has diffused from the n-type layer 4 which includes Ga. When other elements are also used during the formation of the n-type layer 4, these elements may also diffuse into the p-type light-absorbing layer 3.

The aforementioned composition ratios of the p-type light-absorbing layer 3 refer to the overall composition ratio of the p-type light-absorbing layer 3. It is preferable that the compound composition ratios of the aforementioned p-type light-absorbing layer 3 are satisfied throughout the p-type light-absorbing layer 3.

It is preferable for the p-type light-absorbing layer 3 to have a p+ type (p plus type) region on the side facing the p-electrode 2.

It is preferable for the p-type light-absorbing layer 3 to have a p-type (p minus type) region on the n-type layer side. It is even more preferable for the p-type light-absorbing layer 3 to have a p-type (p minus type) region on the n-type layer side and a p+ type (p plus type) region on the p-electrode 2 side.

When elements of the n-type layer 4 diffuses into the p-type light-absorbing layer 3 or element of the p-type light-absorbing layer 3 diffuses into the n-type layer 4, a mixed region with a thickness of 20 [nm] or less may exist between the p-type light-absorbing layer 3 and the n-type layer 4 where elements from both layers have diffused. In this mixed region, 90 [atom%] or less of the metal elements belong to the metal elements 3 which are included in the p-type light-absorbing layer 3, and 10 [atom%] or more of the metal elements belong to the metal elements which included in the n-type layer 4.

The thickness of the p-type light-absorbing layer 3 is obtained by cross-sectional observation or step profiler, and it is preferable that the thickness of the p-type light-absorbing layer 3 be 2000 [nm] or more and 15000 [nm] or less (2 [µm] or more and 15 [µm] or less); more preferably 2500 [nm] or more and 10000 [nm] or less, even more preferably 4000 [nm] or more and 10000 [nm] or less; and more preferably 4000 [nm] or more and 8000 [nm] or less. It is preferable that a difference between the minimum thickness and maximum thickness of the p-type light-absorbing layer 3 be 0 [nm] or more and 100 [nm] or less; and more preferably 0 [nm] or more and 50 [nm] or less. The p-type light-absorbing layer 3 has a rectangular shape.

The p-type light-absorbing layer 3 is preferably formed by a sputtering method, for example. More specifically, a member on which the p-electrode 2 has been formed on the substrate 1 where the member is heated to 300 [°C] or more and 600 [°C] or less, and the deposition is carried out at an oxygen partial pressure of 0.01 [Pa] or more and 4.8 [Pa] or less and a deposition rate of 0.02 [µm/min] or more and 20 [µm/min] or less. Considering the formation of a high-transparency, large-grained polycrystalline film, it is even more preferable that the oxygen partial pressure satisfy 0.55 × d ("0.55" multiplied by "d") [Pa] or more and 1.00 × d ("1.00" multiplied by "d") [Pa] or less, where d represents the deposition rate. It is more preferable that the heating temperature be 350 °C or more and 500 °C or less. The element of M1 can be added during the film formation process. An oxidation treatment may be performed on the surface of the p-type light-absorbing layer 3 before forming the n-type layer 4.

The n-type layer 4 is an n-type semiconductor layer. The n-type layer 4 is positioned between the p-type light-absorbing layer 3 and the n-electrode 5. Preferably, the n-type layer 4 is provided on the p-type light-absorbing layer 3. The n-type layer 4 can be formed by a method such as ALD method.

The n-type layer 4 positioned on the side of the p-type light-absorbing layer 3 preferably includes a compound (oxide) having Ga as a main component. Other oxides may be mixed with the oxide having Ga as a main component, other elements may be doped into the oxide having Ga as a main component, or a mixture of other element-doped oxides and other oxides may be used. The n-type layer 4 may be a single layer or a multilayer. It is preferable that Ga is present at 40 atomic percent or more of the metal elements included in the n-type layer 4 positioned on the side of the p-type light-absorbing layer 3; and more preferably 50 atomic percent or more. The metal element including Ga in the n-type layer 4 may be gradient from the side of the p-type light-absorbing layer 3 toward the n-electrode 5 side. When the n-type layer 4 is a multilayer semiconductor layer (e.g., two layers), it comprises a first n-type layer and a second n-type layer, in order from the side of the p-type light-absorbing layer 3. The element represented by M2 included in the first n-type layer is preferably less than that included in the second n-type layer. When the first n-type layer is a compound (oxide) having Ga as a main component, the second n-type layer preferably comprises a compound (oxide) having Zn as main components and Sn or similar elements.

The n-type layer 4 positioned on the side of the p-type light-absorbing layer 3 preferably includes an oxide including Ga and the element represented by M2. For example, the compound (oxide) having Ga as a main component is the oxide including Ga and the element represented by M2. The n-type layer 4 positioned on the side of the p-type light-absorbing layer 3 preferably includes an oxide including one or more elements selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr and Nd, represented by M2, and Ga. It is preferable that the n-type layer 4 positioned on the side of the p-type light-absorbing layer 3 include 90 wt% or more and 100 wt% or less of the oxide including one or more elements selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr and Nd, represented by M2, and Ga. It is preferable that the compound including Ga as a main component in the n-type layer 4 positioned on the side of the p-type light-absorbing layer 3 be an oxide including M2 and Ga, having an average composition represented by Gaₕ₁M2ᵢ₁Oⱼ₁. It is preferable that h1, i1, and j1 satisfy 1.8 ≤ h1 ≤ 2.1, 0.0 ≤ i1 ≤ 0.2, and 2.9 ≤ j1 ≤ 3.1.

It is preferable that the n-type layer 4 positioned on the side of the p-type light-absorbing layer 3 comprise an oxide including M2 and Ga in an amount of 90 [wt%] or more and 100 [wt%] or less. It is more preferable that the n-type layer 4 positioned on the side of the p-type light-absorbing layer 3 comprise an oxide including M2 and Ga in an amount of 95 [wt%] or more and 100 [wt%] or less. It is even more preferable that the n-type layer 4 positioned on the side of the p-type light-absorbing layer 3 be composed of a compound represented by an oxide including M2 and Ga in an amount of 98 [wt%] or more and 100 [wt%] or less. The Cu included in the n-type layer 4 is not included in the raw material for forming the n-type layer 4, but is diffused from the Cu included in the p-type light-absorbing layer 3. When other elements are also used during the formation of the p-type light-absorbing layer 3, these elements may diffuse into the n-type layer 4.

The thickness of the n-type layer 4 is typically 3 [nm] or more and 100 [nm] or less. When the thickness of the n-type layer 4 is less than 3 [nm], a leak current may occur due to poor coverage of the n-type layer 4, which may deteriorate the characteristics. The thickness is not limited to the above range when the coverage is good. When the thickness of the n-type layer 4 exceeds 50 [nm], the characteristics may be degraded due to excessive high resistance of the n-type layer 4, or a short-circuit current may decrease due to a reduction in transmittance. Therefore, the thickness of the n-type layer 4 is more preferably 3 [nm] or more and 20 [nm] or less, and further preferably 5 [nm] or more and 20 [nm] or less.

The n-electrode 5 is an electrode on the side of the n-type layer 4 that has light transmittance to visible light. The n-electrode 5 is the transparent electrode 10 according to the first embodiment. The n-electrode 5 is preferably in direct contact with the n-type layer 4. The first region R1 or the second region P1 of the n-electrode 5 is preferably in direct contact with the n-type layer 4. When the second region P1 is in direct contact with the n-type layer 4, the first region R1 or the second region P1 that is in direct contact with the n-type layer 4 on the side of the n-type layer 4 is preferably the one located closest to the n-type layer 4 among the first region R1 and the second region P1 which alternately repeat two times or more in the thickness direction of the n-electrode 5.

When the second region P1 is in direct contact with the n-type layer 4, the second region P1 which is in direct contact with the n-type layer, the first region R1, the second region P1, and the first region R1 are preferably arranged in this order from the surface of the n-type layer 4 and the n-electrode 5 on the side of the n-type layer 4 to the opposite side of the n-electrode 5 on the n-type layer 4 side, and each opposing face is preferably in direct contact with each other.

### (Third Embodiment)

A third embodiment relates to a multi-junction solar cell. FIG. 5 shows a cross-sectional diagram of a multi-junction solar cell according to the third embodiment. The multi-junction solar cell 200 shown in FIG. 5 comprises a first solar cell 100 according to the second embodiment on the light incident side, and a second solar cell 201. The light-absorbing layer of the second solar cell 201 has a smaller band gap than that of the p-type light-absorbing layer 3 of the first solar cell 100 according to the second embodiment. Note that the multi-junction solar cell 200 according to this embodiment also includes a solar cell with three or more solar cells joined together.

Since the band gap of the p-type light-absorbing layer (cuprous oxide) 3 of the first solar cell 100 according to the second embodiment is about 2.0 [eV] or more and 2.2 [eV] or less, it is preferable that the band gap of the light absorption layer of the second solar cell 201 be 1.0 [eV] or more and 1.6 [eV] or less. As the light-absorbing layer of the second solar cell 201, one or more compound semiconductor layers selected from the group consisting of CIGS-based and CdTe-based systems with a high In content ratio, crystalline silicon, and perovskite compounds are preferred.

### (Fourth Embodiment)

A fourth embodiment relates to a solar cell module. FIG. 6 shows a perspective diagram of a solar cell module 300 according to the fourth embodiment. The solar cell module 300 shown in FIG. 6 is a solar cell module comprising a first solar cell module 301 and a second solar cell module 302 stacked on top of each other. The first solar cell module 301 is located on the light incident side and uses the solar cell 100 according to the second embodiment. It is preferable that the second solar cell module 302 uses the second solar cell 201.

FIG. 7 shows a cross-sectional diagram of the solar cell module 300. FIG. 7 details the structure of the first solar cell module 301, but does not show the structure of the second solar cell module 302. The structure of the solar cell module is selected according to the light-absorbing layer used in the solar cell, etc., in the second solar cell module 302. As shown in FIG. 7, the solar cell module 300 includes a plurality of submodules 303 enclosed by a broken line including a plurality of solar cells 100 (solar cells) connected electrically in series via wiring 304. The submodules 303 are connected electrically in parallel or series. Adjacent submodules 303 are electrically connected by a busbar 305.

Adjacent solar cells 100 have the n-electrode 5 on the upper side and the p-electrode 2 on the lower side, which are connected by wiring 304. The solar cell 100 of the fourth embodiment has the same structure as the solar cell 100 of the second embodiment, comprising the substrate 1, the p-electrode 2, the p-type light-absorbing layer 3, the n-type layer 4, and the n-electrode 5. The ends of the solar cell 100 in the submodules 303 are connected to a busbar 305, which electrically connects multiple submodules 303 in parallel or series, preferably configured to adjust the output voltage with the second solar cell module 302. Note that the connection configuration of the solar cell 100 shown in the fourth embodiment is just an example and other connection configurations can be used to construct a solar cell module.

### (Fifth Embodiment)

A fifth embodiment relates to a photovoltaic power generation system. The solar cell module according to the fifth embodiment can be used as a generator for power generation. The photovoltaic power generation system of this embodiment generates electricity using a solar cell module and includes, specifically: a solar cell module that generates electricity; a converter from the generated electricity into power; and a battery for storing the generated electricity or a load for consuming the generated electricity. FIG. 8 shows a configuration diagram of the photovoltaic power generation system 400 according to this embodiment. The photovoltaic power generation system shown in FIG. 8 comprises a solar cell module 401 (300), a converter 402, a storage battery 403, and a load 404. Either the storage battery 403 or the load 404 may be omitted. The load 404 may also be configured to utilize the electrical energy stored in the storage battery 403. The converter 402 is a device including circuits or elements that perform power conversion such as voltage transformation and DC-AC conversion, such as a DC-DC converter, a DC-AC converter, or an AC-AC converter. The configuration of the converter 402 can be appropriately selected depending on the generation voltage, the configuration of the storage battery 403, and the load 404.

The submodules 303 that receive light within the solar cell module 401 include solar cells that generate electricity. This electrical energy is converted by the converter 402, stored in the storage battery 403, or consumed by the load 404. It is preferable to add devices such as a solar tracking drive unit for always directing the solar cell module 401 towards the sun, or a concentrator for collecting sunlight to increase power generation efficiency.

The photovoltaic power generation system 400 is preferable for use in real-estate such as houses, commercial facilities and factories, as well as movable property such as vehicles, aircraft and electronic devices. Using solar cells with excellent conversion efficiency according to the embodiment in the solar cell module is expected to increase the amount of power generated.

A vehicle is shown as an example of the use of the photovoltaic power generation system 400. FIG. 9 shows a conceptual diagram of the structure of a vehicle 500. The vehicle 500 shown in FIG. 9 includes a vehicle body 501, a solar cell module 502, a power converter unit 503, a storage battery 504, a motor 505 and tires (wheels) 506. Electricity generated by the solar cell module 502 located on the top of the vehicle body 501 is converted by the power converter unit 503 and charged to the storage battery 504 or consumed by loads such as the motor 505. The vehicle 500 can be driven by rotating the tires (wheels) 506 with the motor 505 using electricity supplied from the solar cell module 502 or the storage battery 504. The solar cell module 502 may not be a multi-junction type, but may be composed only of a first solar cell module equipped with a solar cell 100 according to the first embodiment. When a transparent solar cell module 502 is adopted, it is also preferable to use the solar cell module 502 as a power-generating window on the side of the vehicle body 501 in addition to the top of the vehicle body 501.

An example of using the photovoltaic power generation system 400 is a flying object (drone). The flying object uses the solar cell module 401. The configuration of this embodiment's flying object will be briefly explained using a schematic diagram of a flying object 600 in FIG. 10. The flying object 600 includes a solar cell module 401, a frame 601, a motor 602, rotors 603 and a control unit 604. The solar cell module 401, the motor 602, the rotors 603, and the control unit 604 are provided on the frame 601. The control unit 604 converts and adjusts the power output from the solar cell module 401. The motor 602 uses the electricity output from the solar cell module 401 to rotate the rotors 603. This flying object 600 configuration using the embodiment's solar cell module 401 allows for a flying object that can fly using more power.

### (Sixth Embodiment)

A sixth embodiment relates to a display device. The display device has a transparent electrode sandwiched around a liquid crystal layer or an emissive layer. FIG. 11 shows a schematic diagram of a display device 700 using the transparent electrode 10. The display device 700 includes a first electrode 701, a second electrode 702 and an intermediate layer 703 including a liquid crystal layer or an emissive layer. The embodiment's transparent electrode 10 is used for the first electrode 701 and/or the second electrode 702. It is preferable to use the transparent electrode 10, which has low resistance and high transmittance, as the transparent electrode of the display device 700.

The invention will be described in more detail based on examples, but the invention is not limited to the following examples.

### (Example A)

### (Example A1)

On a glass substrate 1, an ITO (In:Sn=80:20, film thickness 150 [nm]) and ATO (Sn:Sb=98:2, film thickness 100 [nm]) are deposited on the side in contact with the glass as the p-electrode 2 on the rear surface. A Cu₂O layer with a thickness of 6 [µm] is formed as the p-type light-absorbing layer 3 by a sputtering method in an oxygen and argon gas atmosphere on the ATO. After forming the p-type light-absorbing layer 3, a Ga₂O₃ film with a thickness of 10 [nm] is formed as the n-type layer 4. Then, the transparent electrode is formed by ALD with a thickness of 50 [nm] as the n-electrode 5 so that Al is 5% with respect to Zn. The composition ratio of the transparent electrode was u1(Zn) : v1(Al) : w1(O) : x1(N) : y1(H) : z1(C) was 0.97466 : 0.04873 : 0.97466 : 0.00016 : 0.00162 : 0.00016. When forming the transparent electrode, the amount of Al deposited per pulse was adjusted to be moderate (Example A1 reference). The amount of Al deposition per single pulse in Example A1 is overall set to a similar level by adjusting the film formation conditions.

A solar simulator that mimics an AM1.5G light source is used, and the light intensity is adjusted to 1 sun using a standard Si cell under the light source. The measurement is carried out at atmospheric pressure with a room temperature of 25 °C. By sweeping the voltage, the short-circuit current density Jsc (current divided by the cell area) is measured. On the horizontal axis, where voltage is plotted and on the vertical axis, current density is plotted. When the horizontal axis intersects, it becomes the open-circuit voltage Voc. On the measurement curve, when multiplying the voltage and short-circuit current density to make it maximum, they are defined as Vmpp and Jmpp (maximum power point), respectively. Therefore, FF = (Vmpp * Jmpp) / (Voc * Jsc) can be obtained from the fill factor. The conversion efficiency is obtained by Eff. = Voc * Jsc * FF.

The transmittance is evaluated as follows: when the light transmittance in the wavelength range of 700 nm or more and 1000 nm or less is 75% or more, it is evaluated as A; when the light transmittance in the wavelength range of 700 nm or more and 1000 nm or less is 70% or more and less than 75%, it is evaluated as B; and when the light transmittance in the wavelength range of 700 nm or more and 1000 nm or less is less than 70%, it is evaluated as C. The evaluation of transmittance is common to Example A and examples other than Example A.

Jsc is evaluated as follows: when Jsc is 11 [mA/cm²] or more, it is evaluated as A; B when Jsc is 8 [mA/cm²] or more and less than 11 [mA/cm²], it is evaluated as B; and C when Jsc is less than 8 [mA/cm²], it is evaluated as C. The evaluation of FF is common to Example A and examples other than Example A.

Voc is evaluated as follows: when Voc is 1.2 [V] or more, it is evaluated as A; when Voc is 1.1 [V] or more and 1.2 [V] or less it is evaluated as B; and when Voc is 1.1 [V], it is evaluated as C. The evaluation of Voc is common to Example A and examples other than Example A.

FF is evaluated as follows: when FF is 0.65 [-] or more, it is evaluated as A; when FF is 0.6 [-] or more and less than 0.65 [-], it is evaluated as B; and when FF is 0.6 [-], it is evaluated as C. The evaluation of FF is common to Example A and examples other than Example A.

Conversion efficiency is evaluated as follows: when the conversion efficiency is 8.5 [%] or more, it is evaluated as A; when the conversion efficiency is 6 [%] or more and 8.5 [%] or less, it is evaluated as B; and when the conversion efficiency is less than 6 [%], it is evaluated as C. The evaluation of conversion efficiency is common to Example A and examples other than Example A.

Regarding the dispersion of the element denoted by M0, it is evaluated as follows: A when the first region R1 and the second region P1 are repeated twice or more in the thickness direction of the n-electrode 5; B when the first region R1 and the second region P1 are not repeatedly included in the thickness direction of the n-electrode 5. In other words, when the dispersion of the element denoted by M0 is rated A, the element denoted by M0 is dispersed with a sparse-dense distribution in the thickness direction of the transparent electrode 10 within the compound including Zn, O and the element denoted by M0. Moreover, when the dispersion of the element denoted by M0 is rated A, the element denoted by M0 is dispersed with anisotropy in the thickness direction of the transparent electrode 10 within the compound including Zn, O and the element denoted by M0.

### (Comparative Example A1-1)

On a glass substrate 1, ITO (In:Sn=80:20, film thickness 150 [nm]) and ATO (Sn:Sb=98:2, film thickness 100 [nm]) are deposited on the side in contact with the glass as the p-electrode 2 on the rear surface. A Cu₂O layer with a thickness of 6 [µm] is formed as the p-type light-absorbing layer 3 by a sputtering method in an oxygen and argon gas atmosphere on the ATO. After forming the p-type light-absorbing layer 3, a Ga₂O₃ film with a thickness of 10 [nm] is formed as the n-type layer 4. Then, the transparent electrode of AZO (ZnO including about 5% Al) with a thickness of 50 [nm] as a the n-electrode 5 is formed by ALD to obtain the solar cell 100. u1(Zn) : v1(Al) : w1(O) : x1(N) : y1(H) : z1(C) was 0.97466 : 0.04873 : 0.97466 : 0.00016:0.00162:0.00016. When forming the transparent electrode, the amount of Al deposited per pulse is set to be about twice that of the amount of Al deposited per pulse in the case of forming the transparent electrode in Example 1. The amount of Al deposition per single pulse in Comparative Example A1 is set so that it is overall at a similar level by adjusting the film formation conditions. To adjust the composition, the period of concentration change (the sum of the average thickness of the first region R1 and the average thickness of the second region P1) is made approximately twice. Then, the solar cell is evaluated in the same way as Example A1.

### (Comparative Example A1-2)

On a glass substrate 1, ITO (In:Sn=80:20, film thickness 150 [nm]) and ATO (Sn:Sb=98:2, film thickness 100 [nm]) are deposited on the side in contact with the glass as the p-electrode 2 on the rear surface. A Cu₂O layer with a thickness of 6 [µm] is formed as the p-type light-absorbing layer 3 by a sputtering method in an oxygen and argon gas atmosphere on the ATO. After forming the p-type light-absorbing layer 3, a Ga₂O₃ film with a thickness of 10 [nm] is formed as the n-type layer 4. Then, the transparent electrode of AZO (ZnO including about 5% Al) with a thickness of 50 [nm] is formed by ALD to obtain the solar cell 100. u1(Zn) : v1(Al) : w1(O) : x1(N) : y1(H) : z1(C) was 0.97466 : 0.04873 : 0.97466 : 0.00016 : 0.00162 : 0.00016. When forming the transparent electrode, the amount of Al deposited per pulse is set to be about half that of the amount of Al deposited per pulse in the case of forming the transparent electrode in Example 1. The amount of Al deposition per single pulse in Comparative Example A1-2 is set so that it is overall at a similar level by adjusting the film formation conditions. To adjust the composition, the period of concentration change (the sum of the average thickness of the first region R1 and the average thickness of the second region P1) is made about half. Then, the solar cell is evaluated in the same way as Example A1.

### (Examples A2-A5, Comparative Examples A2-1 to A6-1, Comparative Examples A2-2 to A6-2)

Solar cells 100 of Examples A2-A6 and Comparative Examples A2-1 to A6-1 and Comparative Examples A2-2 to A6-2 are manufactured by changing the formation conditions of the n-electrode 5, which is the transparent electrode 10. The film formation conditions of the n-electrode 5 in the solar cells of Example A are shown in Table 12. The evaluation results of the solar cells of Example A are shown in Table 13. The amount of the element denoted by M0 deposited per pulse when forming the transparent electrode in the comparative examples is adjusted to be about twice or about half that of the amount of the element denoted by M0 deposited per pulse when forming the transparent electrode in the examples. The amount of Al deposited per single pulse in Examples and Comparative Examples is adjusted so that it is overall at a similar level.

When the amount of M0 deposited per pulse is large (compared to the example reference) in the forming of the AZO transparent electrode, the cycle of R1+P1 should be lengthened so that the M0 concentration remains at a similar level. As the amount of M0 deposited per pulse increases, the resistance of the layer rises because the layer becomes highly resistive, which decreases Jsc and conversion efficiency. When the cycle of R1+P1 is long, the ZnO layer including less M0 becomes thicker, reducing the transmittance. On the other hand, when the amount of M0 deposited per pulse is small (compared to the example reference), the cycle of R1+P1 should be shortened so that the M0 concentration remains at a similar level. As the cycle of R1+P1 shortens, Jsc and the conversion efficiency are decreased because the resistance of AZO increases due to spacing between layers including M0 with high resistance. The transmittance increases because the number of oxide layers including wide-gap M0 increases.

### (Example B1)

On a glass substrate 1, ITO (In:Sn=80:20, film thickness 150 [nm]) and ATO (Sn:Sb=98:2, film thickness 100 [nm]) are deposited on the side in contact with the glass as the p-electrode 2 on the rear surface. A Cu₂O layer with a thickness of 6 [µm] is formed as the p-type light-absorbing layer 3 by a sputtering method in an oxygen and argon gas atmosphere on the ATO. After forming the p-type light-absorbing layer 3, a Ga₂O₃ film with a thickness of 10 [nm] (first n-layer) is formed as the n-type layer 4. A ZnSnO (Zn:Sn=80:20) film with a thickness of 14 [nm] is formed as the second n-layer on the Ga₂O₃. Then, the transparent electrode AZO (ZnO including about 5% Al) with a thickness of 50 [nm] is formed by ALD to obtain a solar cell 100. u1(Zn) : v1(Al) : w1(O) : x1(N) : y1(H) : z1(C) was 0.97466 : 0.04873 : 0.97466 : 0.00016 : 0.00162 : 0.00016. When forming the transparent electrode, the amount of Al deposited per pulse is adjusted overall to be moderate. The amount of Al deposition per single pulse in Example B1 is adjusted so that it is overall at a similar level by adjusting the film formation conditions. Then, the solar cell is evaluated in the same way as Example A1.

### (Comparative Example B1-1)

On a glass substrate 1, ITO (In:Sn=80:20, film thickness 150 [nm]) and ATO (Sn:Sb=98:2, film thickness 100 [nm]) are deposited as the p-electrode 2 on the side in contact with the glass. On the ATO, a Cu₂O layer with a thickness of 6 [µm] is formed as the p-type light-absorbing layer 3 by sputtering method in an oxygen and argon gas atmosphere. After forming the p-type light-absorbing layer 3, a Ga₂O₃ film with a thickness of 10 [nm] is formed as the n-type layer 4. A ZnSnO (Zn:Sn=80:20) film with a thickness of 14 [nm] is deposited on the Ga₂O₃ as the second n-layer. Then, an AZO (ZnO containing about 5% Al) transparent electrode with a thickness of 50 [nm] is formed by ALD to obtain the solar cell 100. u1(Zn) : v1(Al) : w1(O) : x1(N) : y1(H) : z1(C) was 0.97466 : 0.04873 : 0.97466 : 0.00016 : 0.00162 : 0.00016. When forming the transparent electrode, the amount of Al deposited per pulse is set to be approximately twice the amount of Al deposited per pulse in the case of the transparent electrode of the embodiment. The amount of Al deposition per single pulse in Comparative Example B1 is adjusted so that it is overall at a similar level by adjusting the film formation conditions. The concentration change cycle of the element denoted by M0 (the average thickness of the first region R1 and the average thickness of the second region P1) is set to be approximately twice as long in order to adjust the composition. The solar cell is then evaluated in the same manner as Embodiment A1.

### (Comparative Example B1-2)

On a glass substrate 1, ITO (In:Sn=80:20, film thickness 150 [nm]) and ATO (Sn:Sb=98:2, film thickness 100 [nm]) are deposited as the p-electrode 2 on the side in contact with the glass. On the ATO, a Cu₂O layer with a thickness of 6 [µm] is formed as the p-type light-absorbing layer 3 by sputtering method in an oxygen and argon gas atmosphere. After forming the p-type light-absorbing layer 3, a Ga₂O₃ film with a thickness of 10 [nm] as is formed as the n-type layer 4. A ZnSnO (Zn:Sn=80:20) film with a thickness of 14 [nm] is deposited on the Ga₂O₃ as the second n-layer. Then, an AZO (ZnO containing about 5% Al) transparent electrode with a thickness of 50 [nm] is formed by ALD to obtain the solar cell 100. u1(Zn) : v1(Al) : w1(O) : x1(N) : y1(H) : z1(C) was 0.97466 : 0.04873 : 0.97466 : 0.00016 : 0.00162 : 0.00016. When forming the transparent electrode, the amount of Al deposited per pulse is set to be approximately half the amount of Al deposited per pulse in the case of the transparent electrode of the example. The amount of Al deposition per single pulse in Comparative Example B1 is adjusted so that it is overall at a similar level by adjusting the film formation conditions. The concentration change cycle of the element denoted by M0 (the average thickness of the first region R1 and the average thickness of the second region P1) is set to be approximately half as long in order to adjust the composition. The solar cell is then evaluated in the same manner as Embodiment A1.

### (Embodiments B2-B5, Comparative Examples B2-1 to B6-1, and Comparative Examples B2-2 to B6-2)

Solar cells of embodiments B2-B6, comparative examples B2-1 to B6-1, and comparative examples B2-2 to B6-2 are manufactured by changing the formation conditions of the transparent electrode 10, which is the n-electrode 5. The film deposition conditions for the n-electrode 5 of the solar cells of embodiment B are shown in the table of FIG. 14. The evaluation results of the solar cells of embodiment B are shown in the table of FIG. 15. In the comparative examples, the amount of the element denoted by M0 deposited per pulse when forming the transparent electrode is set to be approximately twice or approximately half the amount of the element denoted by M0 deposited per pulse when forming the transparent electrode of the embodiment. The amount of Al deposition per single pulse in both embodiments and comparative examples is adjusted so that it is overall at a similar level by adjusting the film formation conditions.

In embodiment A, the AZO transparent electrode was deposited on a Ga₂O₃ film, whereas in embodiment B, it was deposited on a ZnSnO film. Regardless of the underlying material, the AZO transparent electrode exhibited similar characteristics in terms of solar cell performance and transmittance.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Some elements are expressed only by element symbols thereof.

Hereinafter, clauses of the embodiments are noted.
Clause 1 A transparent electrode comprising a compound as a main component including Zn, O and an element denoted by M0, wherein
   the element denoted by M0 is dispersed in the compound including Zn, O and the element denoted by M0 with sparse-dense distribution in the thickness direction.
Clause 2 The transparent electrode according to clause 1, wherein
   a first region having a higher ratio of the element denoted by M0 and a second region having a lower ratio of the element denoted by M0 are alternately repeated twice or more in the thickness direction.
Clause 3 The transparent electrode according to claim 1 or 2, wherein
   the compound further includes N.
Clause 4 The transparent electrode according to any one of clauses 1 to 3, wherein
   1 [atom%] or more and 10 [atom%] or less in the transparent electrode is the element denoted by M0.
Clause 5 The transparent electrode according to clause 2, wherein
   3 [atom%] or more and 10 [atom%] or less in the first region is the element denoted by M0, and
   1 [atom%] or more and 8 [atom%] or less in the second region is the element denoted by M0.
Clause 1 The transparent electrode according to Claim 2 or 5, wherein
   a relationship Zn : M0 : O : N : H : C = u3 : v3 : w3 : x3 : y3 : z3 in the first region is present, $u 3 + v 3 + w 3 + x 3 + y 3 + z 3 = 2$ is satisfied,
   a relationship Zn : M0 : O : N : H : C = u4 : v4 : w4 : x4 : y4 : z4 is present in the second region, $u 4 + v 4 + w 4 + x 4 + y 4 + z 4 = 2$ is satisfied, and
   v3 is 1.194 times or more and 3.885 times or less of v4.
Clause 7 The transparent electrode according to clause 2, 5, or 6, wherein,
   a relationship Zn : M0 : O : N : H : C = u1 : v1 : w1 : x1 : y1 : z1 is present in the compound including Zn, O and the element denoted by M0; and u1 + v1 + w1 + x1 + y1 + z1 = 2, 0.95 ≤ (u1 + v1) ≤ 1.15, u1 > 0 and v1 > 0 are satisfied, and
   the compound has a composition represented by Zn : M0 : O : N : H : C = u3 : v3 : w3 : x3 : y3 : z3 in the first region; u3 + v3 + w3 + x3 + y3 + z3 = 2 is satisfied; a relationship Zn : M0 : O : N : H : C = u4 : v4 : w4: x4 : y4 : z4 is present in the second region; u4 + v4 + w4 + x4 + y4 + z4 = 2 is satisfied; v3 is 1.194 times or more and 3.885 times or less of v4; u3 is 0.971 times or more and 0.995 times or less of u4; w3 is 0.971 times or more and 0.995 times or less of w4; y3 is 0.971 times or more and 0.995 times or less of y4; z3 is 0.971 times or more and 0.995 times or less of z4; u3 is 0.986 times or more and 0.995 times or less of u1 v3 is 1.194 times or more and 1.577 times or less of v1; w3 is 0.986 times or more and 0.995 times or less of w1; x3 is 0.986 times or more and 0.995 times or less of x1; y3 is 0.986 times or more and 0.995 times or less of y1; z3 is 0.986 times or more and 0.995 times or less of z1; u4 is 1.000 times or more and 1.015 times or less of u1; v4 is 1.000 times or more and 1.015 times or less of v1; w4 is 1.000 times or more and 1.015 times or less of w1; x4 is 1.000 times or more and 1.015 times or less of x1; and y4 is 1.000 times or more and 1.015 times or less of y1; and z4 is 1.000 times or more and 1.015 times or less of z1.
Clause 8 The transparent electrode according to any one of clauses 1 to 7, wherein
   the compound including Zn, O and the element denoted by M0 comprises 95 wt% or more and 100 [wt%] or less of the transparent electrode.
Clause 9 The transparent electrode according to any one of clauses 1 to 8, wherein
   one cycle of the concentration change of the element denoted by M0 in the thickness direction is 0.8 [nm] or more and 2 [nm] or less.
Clause 10 The transparent electrode according to clause 2, 5, or 7, wherein
   the region where the first region having a higher ratio of the element denoted by M0 and the second region having a lower ratio of the element denoted by M0 are alternately repeated twice or more in the thickness direction is 80% or more and 100% or less of the thickness of the transparent electrode.
Clause 11 A solar cell comprising:
   a p-electrode;
   an n-electrode;
   a p-type light absorbing layer comprising a cuprous oxide compound on the p-electrode;
   an n-type layer between the p-type light absorbing layer and the n-electrode; and
   a transparent electrode according to any one of clauses 1 to 10 on the n-type layer.
Clause 12 A multi-junction solar cell comprising the solar cell according to clause 11.
Clause 13 A solar module comprising the solar cell according to clause 11.
Clause 14 A photovoltaic power generation system that generates electricity comprising the solar module according to clause 13.

### [Reference Signs List]

- 10: :Transparent electrode
- 1: :Substrate
- 2: :p-electrode
- 3: :p-type light-absorbing layer
- 4: :n-type layer
- 5: :n-electrode
- 100: :Solar cell
- 200: :Multi-junction solar cell
- 201: :Second solar cell
- 300: :Solar cell module
- 301: :First solar cell module
- 302: :Second solar cell module
- 303: :Submodule
- 304: :Wiring
- 305: :Busbar
- 400: :Photovoltaic power generation system
- 401: :Solar cell module
- 402: :Converter
- 403: :Storage battery
- 404: :Load
- 500: :Vehicle
- 501: :Vehicle body
- 502: :Solar cell module
- 503: :Power converter unit
- 504: :Storage battery
- 505: :Motor
- 600: :Flying object
- 601: :Frame
- 602: :Motor
- 603: :Rotor
- 604: :Control unit

## Claims

1. A transparent electrode comprising a compound as a main component including Zn, O and an element denoted by M0, wherein
the element denoted by M0 is dispersed in the compound including Zn, O and the element denoted by M0 with sparse-dense distribution in the thickness direction.

2. The transparent electrode according to claim 1, wherein
a first region having a higher ratio of the element denoted by M0 and a second region having a lower ratio of the element denoted by M0 are alternately repeated twice or more in the thickness direction.

3. The transparent electrode according to claim 1 or 2, wherein
the compound further includes N.

4. The transparent electrode according to any one of claims 1 to 3, wherein
1 [atom%] or more and 10 [atom%] or less in the transparent electrode is the element denoted by M0.

5. The transparent electrode according to claim 2, wherein
3 [atom%] or more and 10 [atom%] or less in the first region is the element denoted by M0, and
1 [atom%] or more and 8 [atom%] or less in the second region is the element denoted by M0.

6. The transparent electrode according to Claim 2 or 5, wherein
a relationship Zn : M0 : O : N : H : C = u3 : v3 : w3 : x3 : y3 : z3 in the first region is present, $u 3 + v 3 + w 3 + x 3 + y 3 + z 3 = 2$ is satisfied,
a relationship Zn : M0 : O : N : H : C = u4 : v4 : w4 : x4 : y4 : z4 is present in the second region, $u 4 + v 4 + w 4 + x 4 + y 4 + z 4 = 2$ is satisfied, and
v3 is 1.194 times or more and 3.885 times or less of v4.

7. The transparent electrode according to claim 2, 5, or 6, wherein,
a relationship Zn : M0 : O : N : H : C = u1 : v1 : w1 : x1 : y1 : z1 is present in the compound including Zn, O and the element denoted by M0; and u1 + v1 + w1 + x1 + y1 + z1 = 2, 0.95 ≤ (u1 + v1) ≤ 1.15, u1 > 0 and v1 > 0 are satisfied, and
the compound has a composition represented by Zn : M0 : O : N : H : C = u3 : v3 : w3 : x3 : y3 : z3 in the first region; u3 + v3 + w3 + x3 + y3 + z3 = 2 is satisfied; a relationship Zn : M0 : O : N : H : C = u4 : v4 : w4: x4 : y4 : z4 is present in the second region; u4 + v4 + w4 + x4 + y4 + z4 = 2 is satisfied; v3 is 1.194 times or more and 3.885 times or less of v4; u3 is 0.971 times or more and 0.995 times or less of u4; w3 is 0.971 times or more and 0.995 times or less of w4; y3 is 0.971 times or more and 0.995 times or less of y4; z3 is 0.971 times or more and 0.995 times or less of z4; u3 is 0.986 times or more and 0.995 times or less of u1 v3 is 1.194 times or more and 1.577 times or less of v1; w3 is 0.986 times or more and 0.995 times or less of w1; x3 is 0.986 times or more and 0.995 times or less of x1; y3 is 0.986 times or more and 0.995 times or less of y1; z3 is 0.986 times or more and 0.995 times or less of z1; u4 is 1.000 times or more and 1.015 times or less of u1; v4 is 1.000 times or more and 1.015 times or less of v1; w4 is 1.000 times or more and 1.015 times or less of w1; x4 is 1.000 times or more and 1.015 times or less of x1; and y4 is 1.000 times or more and 1.015 times or less of y1; and z4 is 1.000 times or more and 1.015 times or less of z1.

8. The transparent electrode according to any one of claims 1 to 7, wherein
the compound including Zn, O and the element denoted by M0 comprises 95 wt% or more and 100 [wt%] or less of the transparent electrode.

9. The transparent electrode according to any one of claims 1 to 8, wherein
one cycle of the concentration change of the element denoted by M0 in the thickness direction is 0.8 [nm] or more and 2 [nm] or less.

10. The transparent electrode according to claim 2, 5, or 7, wherein
the region where the first region having a higher ratio of the element denoted by M0 and the second region having a lower ratio of the element denoted by M0 are alternately repeated twice or more in the thickness direction is 80% or more and 100% or less of the thickness of the transparent electrode.

11. A solar cell comprising:
a p-electrode;
an n-electrode;
a p-type light absorbing layer comprising a cuprous oxide compound on the p-electrode;
an n-type layer between the p-type light absorbing layer and the n-electrode; and
a transparent electrode according to any one of claims 1 to 10 on the n-type layer.

12. A multi-junction solar cell comprising the solar cell according to claim 11.

13. A solar module comprising the solar cell according to claim 11.

14. A photovoltaic power generation system that generates electricity comprising the solar module according to claim 13.
